# EUROPEAN PATENT SPECIFICATION

(11) **EP 3 550 597 B1**
(45) Date of publication and mention of the grant of the patent: **20.01.2021**
(21) Application number: 19176210.3
(22) Date of filing: 24.06.2016
(51) Int. Cl.: H01L 21/67

(54) **PRESSURIZED HEATED ROLLING PRESS FOR MANUFACTURE OF PHOTOVOLTAIC CELLS**
UNTER DRUCK STEHENDE BEHEIZTE WALZENPRESSE ZUR HERSTELLUNG VON FOTOVOLTAIKZELLEN
PRESSE À ROULEMENT CHAUFFÉ SOUS PRESSION POUR LA FABRICATION DE CELLULES PHOTOVOLTAIQUES

(30) Priority: 25.06.2015 US 201562184712 P; 23.06.2016 US 201615191375
(43) Date of publication of application: 09.10.2019
(62) Divisional of application: 16745889.2
(73) Proprietor: Alta Devices, Inc., Sunnyvale, CA 94085 (US)
(72) Inventor: SORABJI, Khurshed, Sunnyvale, California 94085 (US); YOSHIDA, Steven, Sunnyvale, California 94085 (US); SANFORD, Eric, Sunnyvale, California 94085 (US)
(74) Representative: Boult Wade Tennant LLP

(56) References cited:
- WO-A1-2007/080822
- WO-A1-2014/046810
- JP-A- 2006 120 998

## Description

### FIELD OF THE INVENTION

The present invention relates generally to manufacturing techniques involving assemblies and more particularly to an improved method of manufacturing an assembly including higher-yielding cell feeders, a pressure-controlled thermal treatment process and apparatus, and an improved assembly process for a high throughput system.

### BACKGROUND OF THE INVENTION

Manufacturing processes which involve the assembly of components can be performed manually, automatically, or in combination, often in relation to the complexity of the manufacturing process. For instance, assembly processes that press a first component to a second component in a gluing operation often require compression resulting from force on the first component to the second component where an adhesive is affixed in advance in between. The steps involved in this basic assembly process can be simple or complex, in relation to the sensitivity, characteristics and nature of the components as well as the environment of the process itself. One method may involve a manual effort using a hand-guided light touch to press a first component onto the second to ensure that neither component is damaged based upon the experience of the operator manually performing the process. Another method may involve an automated robot device that is able to lift a first component from a tray and then align the first component over a second component having an adhesive coating, and press the first component onto the second component in relation to a control algorithm. Manual processes are often more difficult in environments that are caustic and high temperature, and often automated processes are difficult in processes that have delicate or sensitive components involved. Similarly, manual processes often are lower yield producing for higher-value components and automated processes having higher yields are often for lower-valued components. What is desired is an improvement to manufacturing processes that may produce higher yields of assembly where the assemblies include higher-valued and often sensitive components.

Often in the manufacturing of photovoltaic solar cells and photovoltaic solar cell components into photovoltaic devices such as solar mats, multiple laminate layers are applied to a carrier plate where both the contact and alignment are required to be precise and within particular pressure ranges as the components for example, solar cells are sensitive such that they may be easily broken or damaged during manufacture. As a result, often portions of assembly are manual with lower yields. Additionally, certain follow-on steps of the assembly process often involve high temperatures for curing the cell assemblies in which manual involvement may be dangerous or in some situations, impossible. As yields are sought to be improved, often more automated approaches are introduced which then create additional breakage or damage to the components during assembly, or in other situations, require additional steps to the existing processes which do not substantially reduce the processing times.

In WO 2014/046810 there is described a system that generally comprises a first conveyor including a receptacle configured to receive a photovoltaic (PV) cell module preassembly; a vacuum applicator; a pressure applicator; a curing applicator; and a second conveyor. The second conveyor is arranged opposing the first conveyor to seal the receptacle, and is configured to function as a press bladder for the pressure applicator. The vacuum applicator, the pressure applicator, and the curing applicator are configured to respectively process the PV cell module preassembly at spatially distinct positions of the receptacle. The first or second conveyor is configured to transport the receptacle from position to position from the vacuum applicator to the pressure applicator and from the pressure applicator to the curing applicator. The system is configured and operable to form a cured PV cell module. A method is also described that employs the system to press cure PV cell module preassemblies to prepare cured PV cell modules.

In JP 2006 120998 there is described a manufacturing apparatus that comprises a positioning belt, a deliverably adjacent heating belt, and a retain belt opposite the positioning belt and the heating belt so as to bridge across both; and controls both the heating belt and the retain belt at specified temperatures. Guide grooves corresponding to the shape of an inter-connector are formed in the outer sides of both belts. A method of manufacturing a solar cell module uses the apparatus, and has a step of firmly holding a solar battery cell and the inter-connector with the heating belt and the retain belt and soldering with the inter-connector shed in both guide grooves while carrying them.

In WO 2007/080822 there is described a connection method and a connection apparatus capable of preventing cracking and warpage due to heat stress and improving the yield even when an ultra-thin element substrate is used in connecting a solar cell element by means of TAB-lead soldering. When the fusion bonding of a TAB lead is finished in a fusion bonding zone for fusion-bonding solder, a workpiece is moved from the fusion bonding zone and carried through each of the subsequent three cooling zones by carrying belts. Above the carrying belt of each cooling zone is provided a pressing plate that has a pressing pad elevatable by an air cylinder and controlled at a predetermined temperature through a cooling plate and cools the fusion-bonded part pressed with the pressing pad. Closely below the carrying belt is provided a lower cooling plate whose temperature is electrically controlled.

Nonetheless, with demand for photovoltaic cells increasing and the utility of the cells being incorporated into more commercial opportunities in varied markets worldwide, there is a need for improvements to the standard manufacturing assembly processes, in the photovoltaic cell area as well as other assembly areas, to improve the yield without increasing damage to sensitive components, to reduce the risks to those involved in the manual processes while incorporating an approach having a lighter-touch in the assembly process, and to reduce the time to process steps in the assembly, safely.

### SUMMARY OF THE INVENTION

According to the present invention there is provided a system having the features of claim 1 for connecting photovoltaic cells.

A method and system for connecting a plurality of materials using pressure and curing is also described.

In one arrangement, a system for connecting a plurality of materials using pressure and curing comprises a flexible component feeder source for providing the plurality of materials at a first location; a vacuum conveyor for receiving the plurality of materials at the first location wherein the vacuum conveyor includes a plurality of openings for a predetermined vacuum to hold the plurality of materials in place on the vacuum conveyor; a moving belt that is adaptively positioned above the vacuum conveyor at a second location, the vacuum conveyor and the moving belt being arranged to be driven in a predetermined relation to one another for conveying the received plurality of materials from the first location to a second location along the vacuum conveyor; a vacuum pressure source for applying a predetermined vacuum pressure from at least one of the plurality of openings towards the moving belt and the vacuum conveyor as the plurality of materials are conveyed from the second location to a third location, creating a force compressing the plurality of materials; and a curing source at a second location for curing the compressed plurality of materials.

There is also described a method for connecting a plurality of materials using pressure and curing which comprises receiving the plurality of materials on the vacuum conveyor at a first location wherein the vacuum conveyor includes a plurality of openings for a predetermined vacuum pressure to hold the plurality of materials in place on the vacuum conveyor; conveying the received plurality of materials from the first location to a second location along the vacuum conveyor, where a moving belt is adaptively positioned above the vacuum conveyor at the second location and the vacuum conveyor and the moving belt are arranged to be driven in a predetermined relation to one another; and applying a predetermined vacuum pressure from at least one of the plurality of openings towards the moving belt and the vacuum conveyor as the plurality of materials are conveyed from the second location to a third location, creating a force compressing the plurality of materials; and curing the compressed plurality of materials.

There is also described a flexible component feeder source comprising a flexible base suitable for protecting and receiving one or more photovoltaic cells for processing. The feeder source, in a preferred arrangement, includes a base having a linear shape when opened and forms a roll when rolled.

### BRIEF DESCRIPTION OF THE SEVERAL VIEWS OF THE DRAWINGS

The drawings referenced herein form a part of the specification. Features shown in the drawings are meant as illustrative of only some embodiments of the invention, and not of all embodiments of the invention, unless otherwise explicitly indicated, and implications to the contrary are otherwise not to be made.
FIG. 1 diagrams illustratively an approach for processing photovoltaic cells.
FIGs. 2A and 2B diagram a flexible tape feeder having a plurality of photovoltaic cells.
FIGs. 2C and 2D depict two methods for holding the photovoltaic cells in the tape feeder.
FIG. 3 diagrams a method of processing photovoltaic cells.
FIG. 4 diagrams a vacuum conveyor and a moving belt in relation arrangement.
FIG. 5 diagrams a vacuum conveyor and a moving belt in relational arrangement when under pressure from a vacuum source such as a vacuum pump creating a downward pressure.

### DETAILED DESCRIPTION

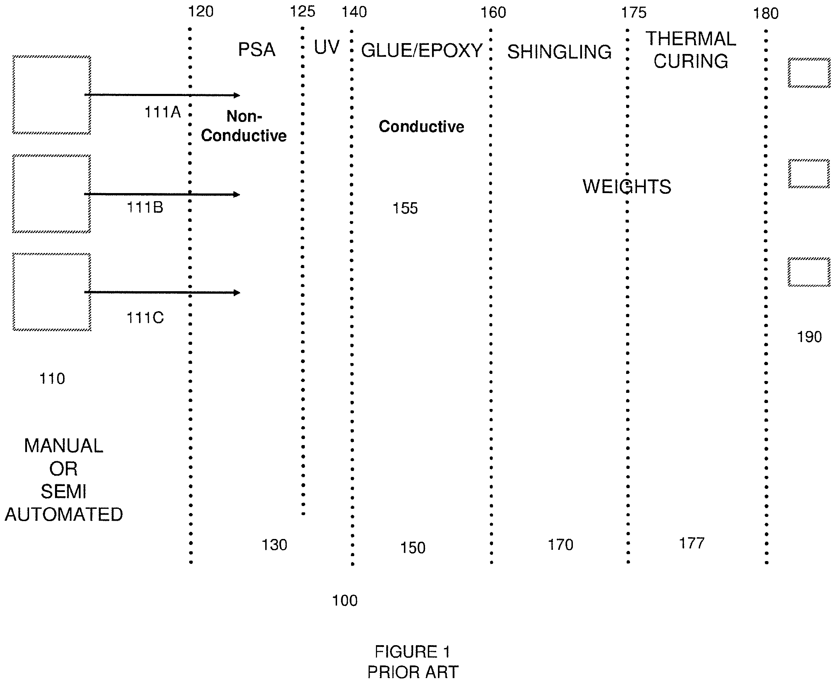

FIG. 1 diagrams illustratively an approach 100 for processing photovoltaic cells. From FIG. 1, a series of stacked cells 110 is located at the source of the approach 100 where each cell component is stacked in position to be processed in accordance with one of three processing lanes, 111A, 111B and 111C. Typically, the stacked cell components may be manually removed from the stacking and placed on a moving conveyor for processing. The stacked cells are often referred to as a 'coin stack' due to their physical arrangement. Human intervention is often necessitated due to the possibility of damage to the cells and the difficulty of the alignment of sensitive components by automated devices. Human intervention is also often necessitated as the cells are typically sticky or may have other material surface issues that require additional care in separating out the individual cells from one another in the coin stack. In certain situations, some automated equipment may be used in a limited manner though it should be realized that this process is typically a low speed process resulting in less than 10 parts per hour.

Once the components are aligned, the process proceeds to 120. At 120, the cells are prepared for a pressure sensitive adhesion (PSA) step. The PSA step 130 may involve application of a pressure sensitive adhesive which, when the component is placed into contact with another component or material, creates a bond wherein each of the two parts are securely affixed to one another. Once the PSA step is completed, the cells move to 125 for UV curing which may comprise curing using ultra-violet (UV) light (i.e., a UV-cure tunnel).

At 140, the cells then move to a gluing step at 150. In some situations, one side of a cell may have adhesive applied to it, in other situations, adhesive may be applied to one or more component parts. Glue may be applied by hand or by equipment though the latter is often difficult. Once the gluing step is completed, the cells move to a shingling step 160.

At shingling step 160, the cells are coupled together through preferably a shingling process 170. The shingling process involves connecting the photovoltaic cells together. Examples of this process are described in US Patent Publication No. 2013/0206213.

It is typical to place weights or apply other physical devices, such as rollers, to at least one of the component portions in order to create a secure bond between the two components. Using weights at 175, while typical, creates additional risks as the use of weights may cause sensitive components to be damaged or require further hardware replacement during operations which may be difficult or expensive. Alternatively, it is also known to use clamps to achieve a similar effect.

At 175, the cells are prepared for the curing step. The curing step 177 may involve ovens, and other thermal or light-based processes. Once the curing step is completed, the cell then moves to 180. At 180, the processing is completed for the affected photovoltaic cell and the completed photovoltaic cell results at 190.

As used herein, the term 'components' and 'materials' may include Gallium Arsenide (GaAs) based components or other photovoltaic components such as photovoltaic cells for example, flexible, thin-film photovoltaic devices comprising semiconductor material, which may or may not be single-crystal, including but not limited to Group III-V materials such as GaAs, AlGaAs, InGaAs, AlInGaAs, InGaAsP, InGaP, AlInGaP, and AllnP (and combinations thereof); Group IV materials such as Si, amorphous Si, Ge, SiGe; Group II-VI materials such as CdTe; other materials such as CIGS (Copper indium gallium (di)selenide), perovskites such as lead halides, organic semiconductors, CZTS, CZTSSe, and dye-sensitized photovoltaic absorber materials, and will typically be layered arrangements of materials which have one or more interface layers that promote a fixed arrangement as between the material layers following a processing sequence.

Examples of such materials, without limitation, may include photovoltaic cells, solar cells, solar panels, layered plastic components, electronic components, high density interconnects, chips, chips on flex, mixed composition materials having multiple layers arranged to be securely arranged with one another, and combinations thereof, for instance.

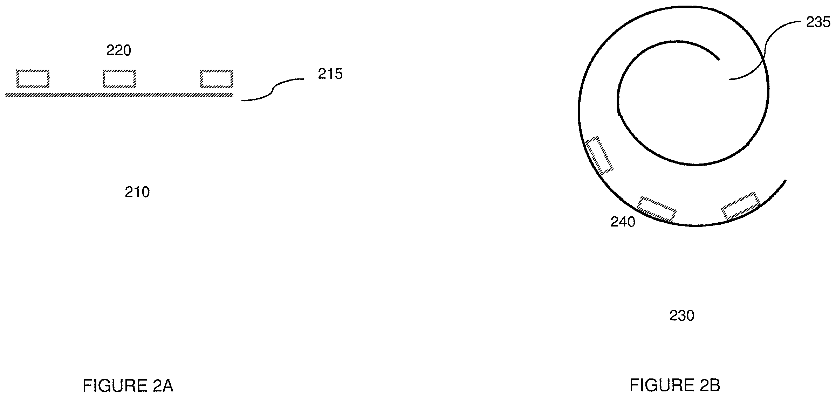

FIGs. 2A and 2B diagram a flexible tape feeder 210 having a plurality of photovoltaic cells 220 in connectable arrangement with the tape base 215. The tape feeder, or tape carrier, provides a source of components to be fed into the assembly or process. The flexible tape feeder also provides a flexible backing to flexible cells to be assembled thereby reducing damage to the cells during the feeding process. The use of the tape feeder is preferred over the coin stacking method as the tape feeder provides a reuse aspect, is more protective of the sensitive components arranged thereon, and is more efficient in the assembly operation. The flexible tape feeder may comprise any of polyethylene terephthalate (PET), porous materials including paper, cloth and a combination thereof.

Traditional operations use a coin stacking approach which requires a larger footprint in the assembly process and also does not protectably secure the sensitive devices to be processed. The tape feeder provides a linear flexible base 215 in which sensitive components 220 may be situated, protectively, for processing in the assembly process. The flexible base is of a linear shape when opened and forms a roll when rolled. Alternatively, the flexible base is of linear shape when under taught tension and retracts to a coil shape when tension to the base is absent.

In one arrangement, the linear base of the tape feeder at 230 may be arranged to provide for a coiling capability 235 where once a tape is populated with a plurality of sensitive components 240, the tape may be wound into the shape of a coil or roll. The coiled tape may then be placed at the beginning of the assembly process whereafter humans and/or robots may readily access the sensitive components situated thereon, removing them for processing. As the tape is fed for the process, the coiled arrangement requires less space and the tape may be rolled into a reusable stock tape during the process as each component is removed.

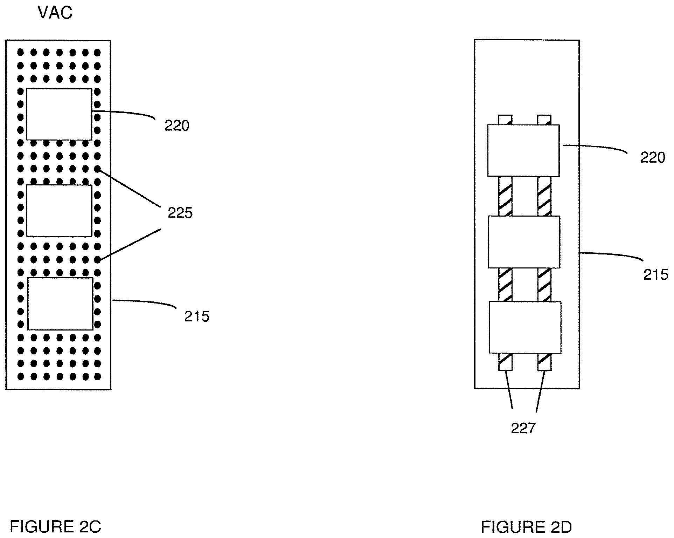

In one arrangement, a width of the flexible base is approximately similar to a size of the photovoltaic cells. In one or more preferred arrangements, instead of a few active lines of processing from traditional stacked cell arrangements involving trays, coin stacking and the like, the present arrangement provides for a six lane processing arrangement using only three tape rolls of components in which a single tape roll can be used to feed a plurality of active processing lanes. In this manner, the use of the tape feeder also promotes a higher speed operation over the traditional approach. The photovoltaic cells can be carried by the tape feeder in a variety of ways. FIGs. 2C and 2D depict two methods for holding the photovoltaic cells in the tape feeder. In a first arrangement shown in Figure 2C a vacuum is applied through the openings 225 in the linear base 215 to hold the photovoltaic cells 220 in place.

In a second arrangement shown in Figure 2D adhesive strips 227 on the linear base 215 are utilized to hold the photovoltaic cells 220 in place. One of ordinary skill in the art readily recognizes that either one or both of the methods together can be utilized to hold the photovoltaic cells 220 in place. For example, in one arrangement, the linear base can use a combination of strategically placed openings 225 and strategically placed adhesive strips 227 and that would be within the scope of the present invention. In an alternate arrangement, various other materials such as, but not limited to, adhesive pads, adhesive tape, glue, PSA, a mechanism to hold the photovoltaic cells in place or a combination of such materials/mechanisms can be used to hold the photovoltaic cells in place.

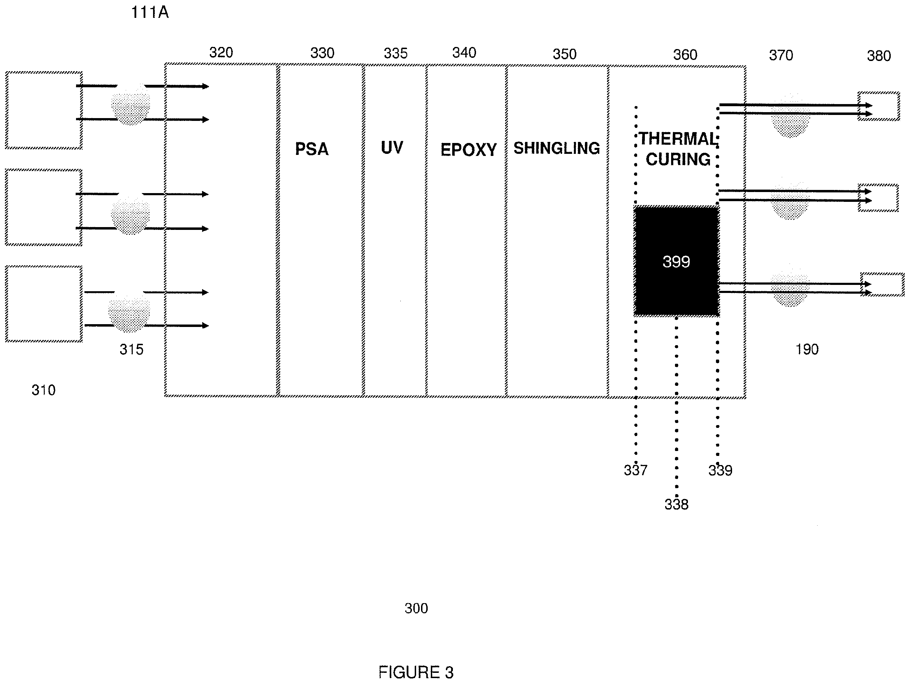

FIG. 3 diagrams a method 300 of processing photovoltaic cells. A tape feeder, described above, is situated at the beginning of a preferred assembly method at 310 as shown in FIG. 3. Preferably, automated equipment 315 removes the sensitive components (or materials) situated on the tape feeder and places them in a predetermined arrangement on the conveyor for processing at 320 corresponding to element 111A shown in Figure 1. In one or more preferred arrangements, the automated equipment may stack two components that are to be securely arranged together atop one another, next to one another, or proximate to one another. The components are then prepped for the next phase of processing, which for the exemplary purposes of FIG. 3 is a phase of receiving a PSA treatment at 330. At 330, the components are prepared and are arranged in layered form with an adhesive based interface between the arranged components as a layered component. The PSA step 330 may involve application of a pressure sensitive adhesive which, when the component is placed into contact with another component or material, creates a bond wherein each of the two parts are securely affixed to one another. Once the PSA step is completed, the cells then move to 335 for UV curing which may comprise curing using ultra-violet (UV) light (i.e., a UV-cure tunnel).

At 340, conductive epoxy, for example, is placed on one or more sides of at least one component to be processed and the components are arranged before the next step of shingling the components.

Thereafter the prepared photovoltaic cells are coupled together via shingling process 350. In one or more arrangements, the next phase is a curing step in which an oven, conventional oven, convection oven, lamp-based source, or thermal source is used, though other possibilities are also envisioned. Curing could also be done by other methods, including but not limited to UV exposure, or evaporation of the solvent in air or in a vacuum, for example.

The layered component is then conveyed along a conveyor for thermal curing without the use of physical pressure plates or devices. At 360, the layered component will traverse from a first location 337 to a second location 338 where at the second location the upper portion of the layered component will be under pressure from a surface of a moving belt in adaptable contact with the upper portion.

At the first location 337, the layered component is situated on the conveyor which is a vacuum conveyor having a plurality of openings therein. Preferably the vacuum conveyor is also comprised of a durable material that provides rigidity and flexibility under pressure, such as being at least partly comprised of metal (SST, Al, etc.), high temp plastic, ceramic, granite, etc.. As the layered material traverses from the first location to the second location, a moving belt is situated above the conveyor and above the layered component. The moving belt can be an idler belt or a driven belt situated above the conveyor and above the layered component. In one arrangement, the moving belt is not in contact with the layered component at the first location 337 but is in contact with the layered component at approximately the second location 338 and for a period of travel proximate thereto depending on the physical arrangement in one or more preferred arrangements. A pressure source, such as an air pump, vacuum pump, or pressurized air flow is positioned proximate to the idler belt or the driven belt and is adaptable and adjustable to control the flow of air from the air source to and across the idler belt or the driven belt and the vacuum conveyor, at 360. In one or more arrangements, a vacuum pump is controlled by a controller in which there are multiple zones of varying pressure between the second location 338 and a third location 339, for example.

At approximately the second location 338, in one or more preferred arrangements, the idler belt is in contact with the upper portion of the layered material. In operation, when no air pressure is provided from the air source, the idler belt will be in 'non-pressured' contact with the upper surface of the layered material, resulting in the idler belt rolling at the same speed to that of the layered component due to the friction created. However, in operation, when there is active air pressure provided from the air source, the idler belt will be in 'pressured' contact with the upper surface of the layered material, resulting in the idler belt applying a pressure force to the upper portion of the layered material thereby forcibly pressuring the upper portion onto the lower portion. The rolling speed of the idler belt will act resistively towards the layered material though the speed may approximate a speed similar to that of the layered component due to the friction created. The idler belt will remain in non-pressured or pressured contact with the upper portion of the layered component until the layered component reaches the third location at 339. The user is able to adaptably adjust the amount of pressure a layered component receives based on the air source, the length of contact with the idler belt, and the environmental conditions of the process.

In one arrangement, the movement of the moving belt is controlled in relation to the time and pressure required for cure. Similarly, a speed of conveyance of the vacuum conveyor, a speed of operation of the moving belt, a material composition of the vacuum conveyor, a material composition of the moving belt, and a length of travel the vacuum conveyor and the moving belt traverse between the second location and the third location is dependent upon temperature and time required for curing. In one arrangement, the moving belt can be an idler belt or a driven belt situated above the conveyor and above the layered component.

At the third location 339, the layered materials have been situated together based on the pressured or non-pressured contact. Depending on the layered materials of the process, the curing time of phase 360 may differ substantially and may also depend on the user's interest in achieving a full or partial cure for the layered material. For instance, where the layered materials are photovoltaic cells, the method provides that approximately one minute per cell matrix would be a reasonable estimate of the curing time required, with a slightly longer time being required if a plurality of matrices is placed in parallel for instance, by example.

After the curing phase at 360, the finished layered components are cooled from the phase of curing, via active or passive cooling and are removed preferably by automated equipment at 370 corresponding to element 190 shown in Figure 1. For clarity, while use of automated equipment is discussed and preferred in certain applications, it is not required as the described method is also capable of being operated without automated equipment and in an arrangement that is partly automated equipment and partly human interaction, without limitation.

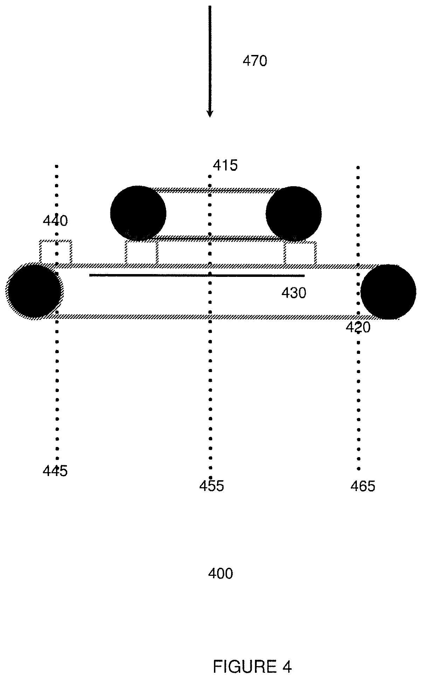

FIG. 4 diagrams a vacuum conveyor 420 and a moving belt 415 in relational arrangement at 400. The moving belt can be an idler belt or a driven belt situated above the conveyor and above the layered component. As shown in FIG. 4, a multi-layer component is entering the drive arrangement 400 at 440 at a first location 445. The multi-layer component is situated on the conveyor (i.e., vacuum conveyor) 420 and is conveyed to a second point 455. At the second location 455, the moving belt 415, for example, an idler belt, may be situated to be in non-pressurized or pressurized contact with the upper portion of the multi-layered component. After possible contact at the second location 455, the multi-layer component is continued to be conveyed along the vacuum conveyor to a third location 465.

As shown in FIG. 4, the vacuum conveyor 420 and the idler belt 415 may be driven by the same motor drive or controller; in another arrangement, the vacuum conveyor 420 and the idler belt 415 are driven independently. In a preferred arrangement the vacuum conveyor 420 is fabricated from steel. In a further preferred arrangement, a pressure plate is present at 430 which provides additional support to layered components on the surface of the vacuum conveyor 420 during a pressurized air flow.

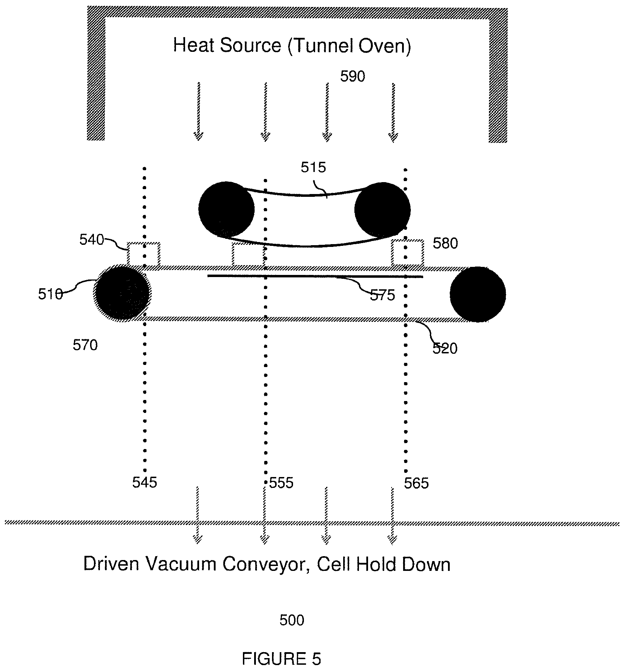

FIG. 5 diagrams a vacuum conveyor 520 and a moving belt 515 in relational arrangement at 500 when under pressure from a vacuum source such as a vacuum pump creating a downward pressure. The moving belt can be an idler belt or a driven belt situated above the conveyor and above the layered component. As shown in FIG. 5, a multi-layer component 540 is entering the drive arrangement 510 at a first location 545. The multi-layer component 540 is situated on the conveyor system (i.e. vacuum conveyor) 520 and is conveyed to a second location at 555. At the second location, the idler belt 515, in the example, is under pressure from a vacuum pump creating a pressurized force downwards such that the upper portion of the multi-layered component 540 is in contact with the idler belt 515. As the multi-layered component 540 is conveyed from the second location 555, the idler belt 515 applies pressure to the upper portion and the upper portion is compressed onto the lower portion which continues to ride along the vacuum conveyor 520 above a reinforcing plate preferably situated at 575, between the second location 555 and the third location 565. The force of the pressure may be adjusted by varying the vacuum pump, etc. After contact at the second location 555 and thereafter, the multi-layer component 540 is continued to be conveyed along the vacuum conveyor to the third location 565 where the contact to the upper portion from the idler belt 515 ceases and the compressed multi-layered component 540 is at a final stage at 580.

In one example, the top of the arrangement 500 is heated by a tunnel oven 590 while the bottom of the arrangement 500 may either be heated, unheated or actively cooled as required by the process. In such an example, temperature may be used to also facilitate the pressure adhesion process.

In operation, when there is no air pressure provided from the air source (or vacuum source), the idler belt will be in 'non-pressured' contact with the upper surface of the layered material, resulting in the idler belt rolling at a speed approximately similar to that of the layered component due to the friction created. In another arrangement, the idler belt is in adjustable contact with the upper portion based upon physical arrangement and air source pressure such that there is no contact with the upper portion absent an air source.

In one arrangement, the movement of the moving belt is controlled in relation to the time and pressure required for cure. Similarly, a speed of conveyance of the vacuum conveyor, a speed of operation of the moving belt, a material composition of the vacuum conveyor, a material composition of the moving belt, and a length of travel the vacuum conveyor and the moving belt traverse between the second location and the third location is dependent upon temperature and time required for curing. In one arrangement, the moving belt can be an idler belt or a driven belt situated above the conveyor and above the layered component.

As is apparent from the above description, the described method is able to achieve significant benefits in the area without the use of weights, clamps and rollers, or other physical devices which add additional wear and create potential damage to sensitive components being processed. Further the process is able to recognize improved throughput and speed in processing and further facilitates the deployment of automated equipment into environments that may be dangerous for human intervention.

## Claims

1. A system for connecting photovoltaic cells (220), comprising:
a flexible component feeder source (210, 230) including a flexible base (215) suitable for receiving the photovoltaic cells (220), wherein the flexible base (215) of the flexible component feeder source (210, 230) is of a linear shape and forming into a coil shape (235) after receiving the photovoltaic cells (220), and wherein the flexible component feeder source (210, 230) is configured to feed the photovoltaic cells (220) to a process that couples together the photovoltaic cells (220);
a vacuum conveyor (420, 520) for receiving at a first location (445, 545) the photovoltaic cells (220) after being coupled together, wherein the vacuum conveyor (420, 520) includes a plurality of openings through which a vacuum is applied to hold the coupled photovoltaic cells (220) in place on the vacuum conveyor (420, 520);
a moving belt (415, 515) adaptively positioned above the vacuum conveyor (420, 520) at a second location (455, 555), wherein the vacuum conveyor (420, 520) and the moving belt (415, 515) are arranged to be driven in a predetermined relation to one another for conveying the received coupled photovoltaic cells (220) from the first location (445, 545) to the second location (455, 555) along the vacuum conveyor (420, 520);
a vacuum source for applying a predetermined vacuum through at least one of the plurality of openings to cause the moving belt (415, 515) to apply a pressure to an upper surface of the coupled photovoltaic cells (220) as the coupled photovoltaic cells (220) are conveyed from the second location (455, 555) to a third location (465, 565), wherein the pressure creates a force that compresses the coupled photovoltaic cells (220); and
a curing source (590) at the second location (455, 555) for curing the compressed coupled photovoltaic cells (220).

2. The system of claim 1, wherein the flexible base (215) of the flexible component feeder source (210, 230) is configured to protect the photovoltaic cells (220) for processing when formed into the coil shape (235).

3. The system of claim 1, wherein the flexible base (215) of the flexible component feeder source (210, 230) is configured to be of the linear shape when under taught tension and to retract to the coil shape (235) when tension to the flexible base (215) is absent.

4. The system of claim 1, wherein the moving belt (415, 515) comprises an idler belt or a driven belt.

5. The system of claim 1, wherein the photovoltaic cells (220) are configured to be removably affixed on the flexible base (215) of the flexible component feeder source (210, 230).

6. The system of claim 5, further comprising an automated device that removes the affixed photovoltaic cells (220) from where positioned on the flexible base (215) of the flexible component feeder source (210, 230).

7. The system of claim 1, wherein the affixed photovoltaic cells (220) are configured to be removable from where positioned on the flexible base (215) of the flexible component feeder source (210, 230) to feed the photovoltaic cells (220) to the process that couples together the photovoltaic cells (220).

8. The system of claim 1, wherein the flexible base (215) of the flexible component feeder source (210, 230) further comprises one or more of polyethylene terephthalate (PET), paper, cloth, or a combination thereof.

9. The system of claim 1, wherein the coupled photovoltaic cells (220) comprise at least an upper portion and a lower portion layered such that the upper portion is atop the lower portion, and at least one of the upper portion or the lower portion includes one or more of an adhesive, an epoxy, or a securing material for securably affixing the upper portion and the lower portion to one another when the coupled photovoltaic cells (220) are compressed.

10. The system of claim 1, wherein the second location (455, 555) is a starting point of a curing step in a manufacturing assembly.

11. The system of claim 1, wherein the vacuum conveyor (420, 520) is relationally arranged with the moving belt (415, 515), and the system further includes a supporting plate (430, 575) positioned beneath an upper conveying portion of the vacuum conveyor (420, 520) for additional support in conveying.

12. The system of claim 1, wherein the moving belt (415, 515) and the vacuum conveyor (420, 520) are an integrated unit, and the system further includes a drive that is common to the vacuum conveyor (420, 520) and the moving belt.

13. The system of claim 1, wherein one or more of a speed of conveyance of the vacuum conveyor (420, 520), a speed of operation of the moving belt (415, 515), a material composition of the vacuum conveyor (420, 520), a material composition of the moving belt (415, 515), and a length of travel the vacuum conveyor (420, 520) and the moving belt (415, 515) traverse between the second location (455, 555) and the third location (465, 565) are dependent upon a temperature and a time required for curing of the coupled photovoltaic cells (220).

14. The system of claim 1, wherein any one of the photovoltaic cells (220) comprises one or more of:
Group III-V materials that comprise one or more of GaAs, AlGaAs, InGaAs, AlInGaAs, InGaAsP, InGaP, AlInGaP, AlInP, or a combination thereof;
Group IV materials that comprise one or more of Si, amorphous Si, Ge, SiGe, or a combination thereof;
Group II-VI materials that comprise CdTe;
copper indium gallium (di)selenide (CIGS),
perovskites that comprise lead halides,
organic semiconductors,
CZTS,
CZTSSe, or
dye-sensitized photovoltaic absorber materials.

15. The system of claim 1, wherein the second location (455, 555) is associated with a thermal curing step provided by a thermal source (590), and wherein the thermal source (590) is one or more of a conventional oven, a convection oven, a lamp-based thermal source, or a resistive heat source.

## Patentansprüche

1. System zum Verbinden von photovoltaischen Zellen (220), umfassend:
eine flexible Komponenten-Zuführquelle (210, 230) mit einer flexiblen Basis (215), die zum Aufnehmen der photovoltaischen Zellen (220) geeignet ist, wobei die flexible Basis (215) der flexiblen Komponenten-Zuführquelle (210, 230) eine lineare Form aufweist und sich nach dem Aufnehmen der photovoltaischen Zellen (220) zu einer Spulenform (235) formt, und wobei die flexible Komponenten-Zuführquelle (210, 230) konfiguriert ist, um die photovoltaischen Zellen (220) einem Prozess zuzuführen, der die photovoltaischen Zellen (220) miteinander koppelt;
einen Saugförderer (420, 520) zum Aufnehmen der photovoltaischen Zellen (220) an einer ersten Stelle (445, 545), nachdem sie miteinander gekoppelt wurden, wobei der Saugförderer (420, 520) eine Mehrzahl von Öffnungen aufweist, durch die ein Unterdruck angelegt wird, um die gekoppelten photovoltaischen Zellen (220) auf dem Saugförderer (420, 520) an Ort und Stelle zu halten;
ein Förderband (415, 515), das an einer zweiten Stelle (455, 555) adaptiv über dem Saugförderer (420, 520) positioniert ist, wobei der Saugförderer (420, 520) und das Förderband (415, 515) eingerichtet sind, um in einer vorgegebenen Beziehung zueinander angetrieben zu werden, um die aufgenommenen gekoppelten photovoltaischen Zellen (220) entlang des Saugförderers (420, 520) von der ersten Stelle (445, 545) zu der zweiten Stelle (455, 555) zu befördern;
eine Unterdruckquelle zum Anlegen eines vorgegebenen Unterdrucks über mindestens eine der Mehrzahl von Öffnungen, um zu bewirken, dass das Förderband (415, 515) einen Druck auf eine Oberseite der gekoppelten photovoltaischen Zellen (220) ausübt, wenn die gekoppelten photovoltaischen Zellen (220) von der zweiten Stelle (455, 555) zu einer dritten Stelle (465, 565) befördert werden, wobei der Druck eine Kraft erzeugt, die die gekoppelten photovoltaischen Zellen (220) zusammendrückt; und
eine Aushärtungsquelle (590) an der zweiten Stelle (455, 555) zum Aushärten der zusammengedrückten, gekoppelten photovoltaischen Zellen (220).

2. System nach Anspruch 1, bei dem die flexible Basis (215) der flexiblen Komponenten-Zuführquelle (210, 230) konfiguriert ist, um die photovoltaischen Zellen (220) für die Verarbeitung zu schützen, wenn sie in die Spulenform (235) geformt ist.

3. System nach Anspruch 1, bei dem die flexible Basis (215) der flexiblen Komponenten-Zuführquelle (210, 230) konfiguriert ist, um eine lineare Form zu haben, wenn sie unter gelernter Spannung steht, und um sich in die Spulenform (235) zurückzuziehen, wenn keine Spannung auf die flexible Basis (215) vorhanden ist.

4. System nach Anspruch 1, bei dem das Förderband (415, 515) ein Freilaufband oder ein angetriebenes Band umfasst.

5. System nach Anspruch 1, bei dem die photovoltaischen Zellen (220) konfiguriert sind, um abnehmbar an der flexiblen Basis (215) der flexiblen Komponenten-Zuführquelle (210, 230) befestigt zu werden.

6. System nach Anspruch 5, ferner mit einer automatischen Vorrichtung, die die befestigten photovoltaischen Zellen (220) von ihrer Position auf der flexiblen Basis (215) der flexiblen Komponenten-Zuführquelle (210, 230) entfernt.

7. System nach Anspruch 1, bei dem die befestigten photovoltaischen Zellen (220) konfiguriert sind, um von dort, wo sie auf der flexiblen Basis (215) der flexiblen Komponenten-Zuführquelle (210, 230) positioniert sind, entfernbar zu sein, um die photovoltaischen Zellen (220) dem Prozess zuzuführen, der die photovoltaischen Zellen (220) miteinander koppelt.

8. System nach Anspruch 1, bei dem die flexible Basis (215) der flexiblen Komponenten-Zuführquelle (210, 230) ferner eines oder mehrere von Polyethylenterephthalat (PET), Papier, Stoff oder einer Kombination davon umfasst.

9. System nach Anspruch 1, bei dem die gekoppelten photovoltaischen Zellen (220) mindestens einen oberen Abschnitt und einen unteren Abschnitt umfassen, die so geschichtet sind, dass der obere Abschnitt oben auf dem unteren Abschnitt liegt, und bei dem mindestens entweder der obere Abschnitt oder der untere Abschnitt einen oder mehrere Klebstoff(e), ein Epoxidharz oder ein Befestigungsmaterial enthält, um den oberen Abschnitt und den unteren Abschnitt sicher aneinander zu befestigen, wenn die gekoppelten photovoltaischen Zellen (220) zusammengedrückt werden.

10. System nach Anspruch 1, bei dem die zweite Stelle (455, 555) den Ausgangspunkt eines Aushärtungsschrittes in einer Fertigungsanordnung bildet.

11. System nach Anspruch 1, bei dem der Saugförderer (420, 520) in Bezug auf das Förderband (415, 515) angeordnet ist und das System ferner eine Stützplatte (430, 575) aufweist, die unter einem oberen Förderabschnitt des Saugförderers (420, 520) zur zusätzlichen Unterstützung beim Fördern angeordnet ist.

12. System nach Anspruch 1, bei dem das Förderband (415, 515) und der Saugförderer (420, 520) eine integrierte Einheit sind und das System ferner einen Antrieb aufweist, der dem Saugförderer (420, 520) und dem Förderband gemeinsam ist.

13. System nach Anspruch 1, bei dem eine oder mehrere von einer Fördergeschwindigkeit des Saugförderers (420, 520), einer Betriebsgeschwindigkeit des Förderbandes (415, 515), einer Materialzusammensetzung des Saugförderers (420, 520), einer Materialzusammensetzung des Förderbandes (415, 515) und einer Länge des Weges, den der Saugförderer (420, 520) und das Förderband (415, 515) zwischen der zweiten Stelle (455, 555) und der dritten Stelle (465, 565) zurücklegen, von einer Temperatur und einer Zeit abhängig sind, die für das Aushärten der gekoppelten photovoltaischen Zellen (220) erforderlich sind.

14. System nach Anspruch 1, bei dem jede der photovoltaischen Zellen (220) eine oder mehrere der folgenden Komponenten umfasst
Materialien der Gruppe III-V, die eines oder mehrere der folgenden Materialien umfassen: GaAs, AlGaAs, InGaAs, AlInGaAs, InGaAsP, InGaP, AlInGaP, AlInP oder eine Kombination davon;
Materialien der Gruppe IV, die eines oder mehrere der folgenden Elemente umfassen: Si, amorphes Si, Ge, SiGe oder eine Kombination davon;
Materialien der Gruppe II-VI, die CdTe umfassen;
Kupfer-Indium-Gallium-(Di)selenid (CIGS),
bleihalogenidhaltige Perowskite,
organische Halbleiter,
CZTS,
CZTSSe, oder
Farbstoff-sensibilisierte photovoltaische Absorbermaterialien.

15. System nach Anspruch 1, bei dem die zweite Stelle (455, 555) einem durch eine Wärmequelle (590) bereitgestellten thermischen Härtungsschritt zugeordnet ist, und bei dem die Wärmequelle (590) ein herkömmlichen Ofen, ein Konvektionsofen, eine auf einer Lampe basierende Wärmequelle und/oder oder eine Widerstandswärmequelle ist.

## Revendications

1. Système pour raccorder des cellules photovoltaïques (220), comprenant :
une source d'alimentation en composant flexible (210, 230) comportant une base flexible (215) adaptée pour recevoir les cellules photovoltaïques (220), où la base flexible (215) de la source d'alimentation en composant flexible (210, 230) a une forme linéaire et prenant une forme de bobine (235) après avoir reçu les cellules photovoltaïques (220), et où la source d'alimentation en composant flexible (210, 230) est configurée pour fournir les cellules photovoltaïques (220) à un procédé qui couple les cellules photovoltaïques (220) ensemble ;
un transporteur à vide (420, 520) pour recevoir à un premier emplacement (445, 545) les cellules photovoltaïques (220) après avoir été couplées ensemble, où le transporteur à vide (420, 520) comporte une pluralité d'ouvertures à travers lesquelles un vide est appliqué pour maintenir les cellules photovoltaïques couplées (220) en place sur le transporteur à vide (420, 520) ;
une courroie mobile (415, 515) positionnée de manière adaptative au-dessus du transporteur à vide (420, 520) à un deuxième emplacement (455, 555), où le transporteur à vide (420, 520) et la courroie mobile (415, 515) sont agencés pour être entraînés dans une relation prédéterminée l'un par rapport à l'autre pour transporter les cellules photovoltaïques couplées reçues (220) du premier emplacement (445, 545) au deuxième emplacement (455, 555) le long du transporteur à vide (420, 520) ;
une source de vide pour appliquer un vide prédéterminé à travers au moins l'une de la pluralité d'ouvertures pour amener la courroie mobile (415, 515) à appliquer une pression sur une surface supérieure des cellules photovoltaïques couplées (220) à mesure que les cellules photovoltaïques couplées (220) sont transportées du deuxième emplacement (455, 555) à un troisième emplacement (465, 565), où la pression crée une force qui comprime les cellules photovoltaïques couplées (220) ; et
une source de durcissement (590) au deuxième emplacement (455, 555) pour durcir les cellules photovoltaïques couplées comprimées (220).

2. Système de la revendication 1, dans lequel la base flexible (215) de la source d'alimentation en composant flexible (210, 230) est configurée pour protéger les cellules photovoltaïques (220) pour le traitement lorsqu'elle prend la forme de bobine (235).

3. Système de la revendication 1, dans lequel la base flexible (215) de la source d'alimentation en composant flexible (210, 230) est configurée pour avoir une forme linéaire lorsqu'elle est sous tension acquise et pour se rétracter en forme de bobine (235) en l'absence de tension appliquée sur la base flexible (215).

4. Système de la revendication 1, dans lequel la courroie mobile (415, 515) comprend une courroie à galets tendeurs ou une courroie entraînée.

5. Système de la revendication 1, dans lequel les cellules photovoltaïques (220) sont configurées pour être fixées de manière amovible sur la base flexible (215) de la source d'alimentation en composant flexible (210, 230).

6. Système de la revendication 5, comprenant en outre un dispositif automatisé qui retire les cellules photovoltaïques fixées (220) de l'endroit où elles sont positionnées sur la base flexible (215) de la source d'alimentation en composant flexible (210, 230).

7. Système de la revendication 1, dans lequel les cellules photovoltaïques fixées (220) sont configurées pour pouvoir être retirées de l'endroit où elles sont positionnées sur la base flexible (215) de la source d'alimentation en composant flexible (210, 230) pour fournir les cellules photovoltaïques (220) au procédé qui couple les cellules photovoltaïques (220) ensemble.

8. Système de la revendication 1, dans lequel la base flexible (215) de la source d'alimentation en composant flexible (210, 230) comprend en outre un ou plusieurs parmi le téréphtalate de polyéthylène (PET), le papier, le tissu, ou une combinaison de ceux-ci.

9. Système de la revendication 1, dans lequel les cellules photovoltaïques couplées (220) comprennent au moins une partie supérieure et une partie inférieure stratifiées de sorte que la partie supérieure soit au-dessus de la partie inférieure, et au moins l'une de la partie supérieure et de la partie inférieure comporte un ou plusieurs parmi un adhésif, un époxy ou un matériau de fixation pour fixer solidement la partie supérieure et la partie inférieure l'une à l'autre lorsque les cellules photovoltaïques couplées (220) sont comprimées.

10. Système de la revendication 1, dans lequel le deuxième emplacement (455, 555) est un point de départ d'une étape de durcissement dans un assemblage de fabrication.

11. Système de la revendication 1, dans lequel le transporteur à vide (420, 520) est agencé en relation avec la courroie mobile (415, 515), et le système comportant en outre une plaque de support (430, 575) positionnée sous une partie de transport supérieure du transporteur à vide (420, 520) pour un support supplémentaire lors du transport.

12. Système de la revendication 1, dans lequel la courroie mobile (415, 515) et le transporteur à vide (420, 520) sont une unité intégrée, et le système comportant en outre un entraînement qui est commun au transporteur à vide (420, 520) et à la courroie mobile.

13. Système de la revendication 1, dans lequel une ou plusieurs parmi une vitesse de transport du transporteur à vide (420, 520), une vitesse de fonctionnement de la courroie mobile (415, 515), une composition de matériau du transporteur à vide (420, 520), une composition de matériau de la courroie mobile (415, 515), et une longueur de déplacement que le transporteur à vide (420, 520) et la courroie mobile (415, 515) traversent entre le deuxième emplacement (455, 555) et le troisième emplacement (465, 565) dépendent d'une température et d'un temps requis pour le durcissement des cellules photovoltaïques couplées (220) .

14. Système de la revendication 1, dans lequel l'une quelconque des cellules photovoltaïques (220) comprend un ou plusieurs parmi :
des matériaux du Groupe III-V qui comprennent un ou plusieurs parmi GaAs, AlGaAs, InGaAs, AlInGaAs, InGaAsP, InGaP, AlInGaP, AlInP, ou une combinaison de ceux-ci ;
des matériaux du Groupe IV qui comprennent un ou plusieurs parmi Si, Si amorphe, Ge, SiGe, ou une combinaison de ceux-ci ;
des matériaux du Groupe II-VI qui comprennent du CdTe ;
du (di)séléniure de cuivre-indium-gallium (CIGS),
des pérovskites qui comprennent des halogénures de plomb,
des semi-conducteurs organiques,
CZTS,
CZTSSe, ou
des matériaux absorbants photovoltaïques à colorant.

15. Système de la revendication 1, dans lequel le deuxième emplacement (455, 555) est associé à une étape de durcissement thermique assurée par une source thermique (590), et où la source thermique (590) est un ou plusieurs parmi un four conventionnel, un four à convection, une source thermique à base de lampe, ou une source de chaleur résistive.
